(19) Europäisches Patentamt
European Patent Office
Office européen des brevets

(11) EP 0 523 597 B1

(12) **EUROPEAN PATENT SPECIFICATION**

(45) Date of publication and mention
of the grant of the patent:
**02.04.1997 Bulletin 1997/14**

(51) Int Cl.⁶: **H01S 3/19**, H01S 3/18

(21) Application number: **92111917.8**

(22) Date of filing: **13.07.1992**

(54) **Semiconductor laser**

Halbleiterlaser

Laser à semi-conducteur

(84) Designated Contracting States:
**DE FR GB NL**

(30) Priority: **15.07.1991 JP 174121/91**
**15.07.1991 JP 174122/91**

(43) Date of publication of application:
**20.01.1993 Bulletin 1993/03**

(73) Proprietor: **SONY CORPORATION**
**Tokyo (JP)**

(72) Inventors:
• **Okuyama, Hiroyuki**
**Shinagawa-ku, Tokyo (JP)**
• **Akimoto, Katsuhiro**
**Shinagawa-ku, Tokyo (JP)**

(74) Representative: **Müller, Frithjof E., Dipl.-Ing.**
**Patentanwälte**
**MÜLLER & HOFFMANN,**
**Innere Wiener Strasse 17**
**81667 München (DE)**

(56) References cited:
**EP-A- 0 380 106**          **FR-A- 2 651 605**
**GB-A- 2 226 698**

• **PATENT ABSTRACTS OF JAPAN vol. 1, no. 16**
**(E-375) 22 January 1986 & JP-A-60 178 684**
• **JAPANESE JOURNAL OF APPLIED PHYSICS,**
**vol. 30, no. 4A, 1 April 1991, Tokyo, JP, pp.**
**L605-L607; Y. KAWAKAMI et al.: 'Optically**
**pumped blue-green laser operation above room**
**temperature in ZnCdSe-ZnSSe MQW structures'**
• **JOURNAL OF ELECTRONIC MATERIALS vol. 12,**
**no. 4, 1983, pp. 653-665; H.J LOZYKOWSKI et al.:**
**'Luminescence properties of MgZnSe prepared**
**by Mg diffusion'**
• **JAPANESE JOURNAL OF APPLIED PHYSICS,**
**PART 2 LETTERS vol. 31, no. 3B, 15 March 1992,**
**Tokyo, JP, pp. L340-L342; H. OKUYAMA et al.:**
**'Optically pumped blue lasing in ZnSe-ZnMgSSe**
**double heterostructures at room temperature'**
• **JAPANESE JOURNAL OF APPLIED PHYSICS,**
**vol. 30, no. 9B, September 1991, Tokyo, JP, pp.**
**L1620-L1623; H. OKUYAMA et al.: 'Epitaxial**
**growth of ZnMgSSe on GaAs substrate by MBE'**

## Description

The present invention generally relates to semiconductor lasers and, more particularly, to a semiconductor laser having a GaAs substrate or InP substrate which can emit a laser beam of short wavelength, such as a blue laser beam, a purple laser beam or a ultraviolet laser beam.

The demand of semiconductor lasers which can emit a laser beam having a short wavelength ranging from a blue laser beam to a ultraviolet laser beam is increased because the demand for recording and/or reproducing an optical disc and a magneto-optical disc, for example, at high density and with high resolution is also increased.

Further, the demand of such a semiconductor laser capable of emitting a short-wavelength laser beam is increased more and more from an industry standpoint because if a semiconductor laser emitting a blue laser beam is realized, then a variety of display devices using a semiconductor laser and a color display device using a three-primary color semiconductor laser can be realized.

The semiconductor laser for emitting a blue or ultraviolet laser beam must be made of a material having a large band gap Eg of direct transition type. In particular, in a double heterojunction semiconductor laser, its cladding layer must be made of a material having a high band gap as that of an active layer.

As conventional optical device materials, II-VI group compound semiconductors, in particular, IIb-VI group compound semiconductors (including mixed IIb-VI compound semiconductors) having a band structure of a direct transition type are expected to be promising semiconductors.

IIa-VI group compound semiconductors are regarded as passive optical devices, in particular, passive semiconductor laser materials because they have a band structure of an indirect transition type and the characteristics thereof are not stable.

Furthermore, it is preferable that a substrate having excellent crystal property and satisfactory productivity and which is well commercially available on the market is utilized as a substrate on which an active layer, cladding layers sandwiching the active layer or the like are grown epitaxially in a semiconductor laser.

FR-A-2 651 605 discloses a light emitting semiconductor device comprising a GaAs or InP substrate, an active layer and a pair of cladding layers sandwiching said active layer, wherein said active layer and said cladding layers being composed of II-VI group compound semiconductors.

Accordingly, it is an object of the present invention to provide an improved semiconductor laser in which the aforesaid shortcomings and disadvantages encountered with the prior art can be eliminated.

More specifically, it is an object of the present invention to provide a semiconductor laser in which commercially-available inexpensive GaAs substrate or InP substrate can be used as a substrate.

Another object of the present invention is to provide a semiconductor laser which can generate a laser beam of short wavelength.

Still another object of the present invention is to provide a semiconductor laser which can be used as a light source for effecting optical recording, magneto-optical recording of high density, optical reproducing and magneto-optical reproduction of high resolution.

A further object of the present invention is to provide a semiconductor laser which can reduce electric power consumption.

Still a further object of the present invention is to provide a semiconductor laser which can effect a color display of high brightness.

Yet a further object of the presenet invention is to provide a semiconductor laser which can reproduce a color image.

In a first aspect, the present invention as defined in claim 1 provides a semiconductor laser comprising: a GaAs substrate, a lower cladding layer on said substrate, an active layer on said lower cladding layer, an upper cladding layer on said active layer, wherein at least one of said lower and upper cladding layers are formed of a II-VI group compound semiconductor, which is characterized in that said semiconductor is of the $Mg_xZn_yCd_{1-x-y}S$ system or $MgS_zSe_{1-z}$ system, and when it is of the $MgS_zSe_{1-z}$ system, said active layer is formed of a II-VI-group compound semiconductor of the $Mg_iCd_{1-i}S$ system.

Acording to one embodiment of this semiconductor laser, the semiconductor is of the $Mg_xZn_yCd_{1-x-y}S$ system, wherein x and y expressing atomic ratios are limited to $0 < x \leq 0.90$ and $0.50 \geq y > 0$. In a further embodiment, the active layer is also formed of a II-VI group compound semiconductor of the $Mg_xZn_yCd_{1-x-y}S$ system, wherein x and y expressing atomic ratios are limited to $0 < x \leq 0.64$ and $0.50 \geq y > 0.11$.

In a preferred embodiment of the above semconductor laser, z and i expresing atomic ratios are limited to $0.85 \leq z \leq 0.95$ and $0.80 \leq i \leq 0.90$.

In a second aspect, the present invention as defined in claim 5 provides a semiconductor laser comprising: an InP substrate, a lower cladding layer on said substrate, an active layer on said lower cladding layer, and an upper cladding layer on said active layer, wherein at least one of said lower and upper cladding layers is formed of a II-VI group compound semiconductor, which is characterized in that said semiconductor is of the $Mg_jZn_kCd_{1-j-k}Se$ system or $MgS_nSe_{1-n}$ system or $Mg_\ell Cd_{1-\ell}S_mSe_{1-m}$ system.

In one embodiment of the semiconductor laser according to the second aspect, said semiconductor is of the $Mg_jZn_kCd_{1-j-k}Se$ system, wherein j and k expressing atomic ratios are limited to $0 < j \leq 0.95$ and $0.50 \geq k \geq 0.05$. In this embodiment, the active layer may also be formed of $Mg_jZn_kCd_{1-j-k}Se$, wherein j and k expressing atomic ratios are limited to $0 < j \leq 0.69$ and $0.50 \geq k \geq 0.18$.

According to a further embodiment of the semiconductor laser of the second aspect, said active layer is formed of a II-VI group compound semiconductor of the CdSSe system or ZnCdSe system and said cladding layers are formed of $Mg_jZn_kCd_{1-j-k}Se$, wherein j and k expressing atomic ratios are limited to $0.23 \leq j \leq 0.95$ and $0.37 \geq k \geq 0.05$.

According to a further embodiment of a semiconductor laser of the second aspect, at least one of said cladding layers is formed of $Mg_\ell Cd_{1-\ell}S_mSe_{1-m}$, wherein $\ell$ and m expressing atomic ratios are limited to $0 < \ell \leq 1$ and $0.88 \geq m \geq 0.03$.

Still in a further embodiment of the semiconductor laser of the second aspect, at least one of said lower and upper cladding layers is formed of $MgS_nSe_{1-n}$, and said active layer is formed of $Mg_pZn_{1-p}Se$. In this embodiment, it is preferred that n and p expressing atomic ratios are limited to $0.03 \leq n \leq 0.13$ and $0.85 \leq p \leq 0.95$.

The semiconductor laser according to both aspects of the present invention may further comprise a capping layer which does not contain Mg and is difficult to be oxidized on said upper cladding layer.

A better understanding of other objects, features, and advantages of the present invention can be gained from a consideration of the following detailed description of illustrative embodiments thereof, in conjunction with the figures of the accompanying drawings, in which:

FIG. 1 is a cross-sectional side view illustrating a fundamental structure of a semiconductor laser according to the present invention;
FIG. 2 is a cross-sectional side view illustrating a semiconductor laser according to an embodiment of the present invention; and
FIG. 3 is a graph of measured results used to explain a relation between lattice constant $\underline{a}$ versus the energy band gap Eg.

Prior to describing preferred embodiments of the invention, a fundamental principle of the present invention will be described below.

In view of the following points, that is, a regular tetrahedron covalent bond radius of IIa-group Mg is large although an atomic number thereof is small; a lattice constant of a IIa-VI group compound semiconductor containing Mg is relatively large, i.e., the IIa-VI group compound semiconductor containing Mg has an advantage for achieving a lattice matching to a GaAs substrate or InP substrate having a relatively large lattice constant a; and the IIa-VI group compound semiconductor containing Mg has a relatively large band gap Eg, mixed II-VI group compound semiconductor of IIa-VI group and IIb-VI group containing Mg can provide a semiconductor laser which can be satisfactorily matched with the GaAs substrate or InP substrate and which is excellently stable in characteristics such as a crystal property. Thus, an emission characteristic of this semiconductor laser is stable and this semiconductor laser can emit a laser beam of a short wavelength.

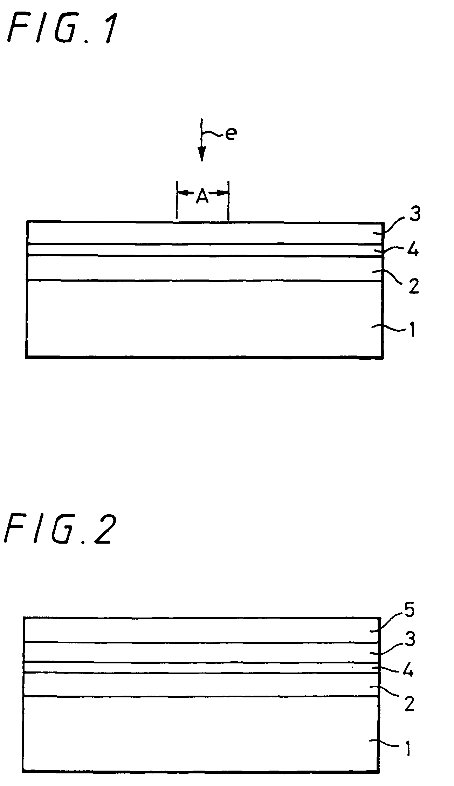

According to the present invention, as fundamentally shown in FIG. 1, at least cladding layers 2, 3 and an active layer 4 are epitaxially grown on a GaAs substrate 1 to form a semiconductor laser. In particular, the cladding layers 2 and 3 are formed of the mixed II-VI group compound semiconductor of the II-VI compound semiconductor containing Mg, i.e. IIa-VI group and IIb-VI group of $Mg_xZn_yCd_{1-x-y}S$ (x and y express atomic ratios).

Further, in the above-mentioned composition, x and y are selected so as to satisfy $0 < x \leq 0.90$ and $0.50 \geq y > 0$, respectively.

Alternatively, in the above-mentioned fundamental structure, the cladding layers 2, 3 and the active layer 4 are formed of the II-VI group compound semiconductor layer of $MgS_zSe_{1-z}$ and $Mg_iCd_{1-i}S$ (z and i express atomic ratios), respectively.

In the above-mentioned compositions, z and i are selected so as to satisfy $0.85 \leq z \leq 0.95$ and $0.80 \leq i \leq 0.90$, respectively.

According to the present invention, at least the cladding layers 2, 3 and the active layer 4 are epitaxially grown on the InP substrate, thereby forming the semiconductor laser. In particular, the cladding layers 2 and 3 are formed of the II-VI group compound semiconductor layer containing Mg.

Further, in the above-mentioned fundamental structure, the cladding layers 2 and 3 are formed of the mixed II-VI group compound semiconductor layer of IIa-VI group and IIb-VI group of $Mg_j Zn_kCd_{1-j-k}Se$ (j and k are atomic ratios).

In this composition, j and k are selected so as to satisfy $0 < j \leq 0.95$ and $0.50 \geq k \geq 0.05$, respectively.

Alternatively, in the above-mentioned fundamental structure, the cladding layers 2 and 3 are formed of the mixed II-VI group compound semiconductor layer of IIa-VI group and IIb-VI group of $Mg_\ell Cd_{1-\ell}S_mSe_{1-m}$ ($\ell$ and m are atomic ratios).

In this composition, $\ell$ and m are selected so as to satisfy $0 < \ell \leq 1$ and $0.88 \geq m \geq 0.03$, respectively.

Furthermore, in the above-mentioned fundamental structure, the cladding layers 2, 3 are formed of II-VI group compound semiconductor layer of $MgS_nSe_{1-n}$ and the active layer 4 is formed of II-VI group compound semiconductor layer of $Mg_pZn_{1-p}Se$ (n and p are atomic ratios).

In this composition, n and p are selected so as to satisfy $0.03 \leq n \leq 0.13$ and $0.85 \leq p \leq 0.95$, respectively.

According to the above-mentioned structures of the present invention, the cladding layers 2 and 3 can be constructed as the semiconductor layers having sufficiently high energy band gap Eg and can be satisfactorily matched with lattice constants (i.e., GaAs substrate: $a = 5.653 Å$ ($1 Å = 10^{-10} m$) and InP substrate: $a = 5.8694$

Å) of the substrates.

Therefore, according to the present invention, since the band gaps of the cladding layers 2 and 3 can be increased, the active layer 4 can be formed of a semiconductor layer whose band gap is small as compared with those of the cladding layers 2 and 3 and whose band gap difference is kept sufficiently as high as 0.2eV to 0.3eV or more so that carriers or light can be confined in the active layer 4 by the cladding layers 2 and 3. Therefore, a variety of semiconductor lasers of photo-excited, electron beam induced or injection types can be constructed, which can generate a laser beam of short wavelength.

It was confirmed that according to the structure based on mixed compound semiconductor of IIa-VI group and IIb-VI group, the semiconductor laser can be obtained, in which the lattice matching with the GaAs substrate or InP substrate can be implemented satisfactorily and which can exhibit stable and excellent emission characteristics regardless of the addition of Mg.

The present invention will now be described with reference to the drawings.

FIG. 1 of the accompanying drawings shows a fundamental structure of a semiconductor laser according to the present invention.

As shown in FIG. 1, the first cladding layer 2, the active layer 4 and the second cladding layer 3 are continuously and epitaxially grown on the substrate 1, in that order, for example by a molecular beam epitaxy (MBE) method or a metal organic chemical vapor deposition (MOCVD) method, thereby forming a double heterojunction semiconductor laser of photo-excited, electron beam induced or injection type.

More specifically, the first cladding layer 2 having a thickness of about 0.1 μm, the active layer 4 having a thickness of about 0.1 to 0.2 μm and the second cladding layer 3 having a thickness of about 0.5 μm are epitaxially grown on the substrate 1, in that order. The cladding layers 2 and 3 and the active layer 4 are respectively formed of n-type layers into which, for example, $Cl$ or Ga is doped. A length of a resonator constructed by the active layer 4 falls in a range of from 100 to 200 μm, for example. A region A extended in the direction perpendicular to the sheet of drawing of FIG. 1 in the central portion constructing the resonator is radiated by an electron beam e from the second cladding layer 3 side. An end face of the resonator, i.e., light emitting end face is constructed by a cleaved facet of crystal, for example.

According to the above-mentioned arrangement, a semiconductor laser of electron beam induced type can be constructed, which radiates a laser beam by an electron beam induction of a power of 10A/cm². 

Further, the photo-excited semiconductor laser can be constructed by exciting the semiconductor structure similar to the electron induced semiconductor by the radiation of a laser beam at a power of about 500 kW/cm², instead of the radiation of electron beam.

Furthermore, a p-n junction injection type semiconductor laser is constructed as follows:

An n-type first cladding layer 2 having a thickness of about 0.1 μm on which $Cl$, Ga, for example, are doped, an active layer 4 having a thickness of about 0.1 to 0.2 μm and a p-type second cladding layer 3 having a thickness of about 0.5 μm on which O, N, for example, are doped are epitaxially grown on an n-type substrate 1, in that order. Then, one electrode (not shown) such as In makes an ohmic contact to the whole rear surface of the substrate 1, for example, and the other electrode of stripe configuration (not shown) made of Au, for example, makes an ohmic contact to the second cladding layer 3 in the region A, for example.

Also in this case, the length of the resonator is selected in a range of from about 100 to 200 μm and the respective end faces of the resonator, i.e., light emitting end face can be formed of a cleaved facet of crystal.

Then, a laser oscillation can be effected according to a re-combination of carriers by the flow of current by applying a predetermined voltage, e.g., voltage of about band gap of the cladding layer across both electrodes.

Example 1

In the semiconductor lasers of the above-mentioned respective types, the substrate 1 is formed of a GaAs substrate and the first, second cladding layers 2, 3 and the active layer 4 are made of compositions expressed by the following chemical formula (1):

$$Mg_xZn_yCd_{1-x-y}S \qquad (1)$$

Then, in these four elements, x and y are selected so as to satisfy the following equations (1) and (2):

$$0 < x \leqq 0.90 \qquad (1)$$

$$0.50 \geqq y > 0 \qquad (2)$$

According to the above-mentioned composition, the first cladding layer, the active layer 4 and the second cladding layer 3 are matched with the GaAs substrate 1 satisfactorily.

Further, in the above-mentioned composition, the band gap Eg of the active layer 4 is selected to be smaller than the band gaps Eg of the first and second cladding layers 2 and 3, and a difference ΔEg therebetween is selected to be larger than at least 0.2eV and preferably larger than 0.3ev. Thus, when the band gap Eg of the active layer 4 is selected in a range of from 3.0eV to 3.9eV (in the wavelength of from about 4132 Å to 3179 Å), then the band gaps Eg of the first and second cladding layers 2 and 3 are selected to be 3.3eV to 4.2ev, which is constantly higher than the band gap Eg of the active layer 4 by 0.3eV. In order for the active layer 4 to have the band gap Eg expressed as 3.0eV $\leq$ Eg $\leq$ 3.9eV in the composition expressed by the foregoing chemical formula (1), x and y expressing atomic ratio must be selected in the following equation (3) and (4) with respect to the chemical formula (1). In that event, x and y of the first and second cladding layers 2 and 3 are selected as in the following equations (5) and (6) with respect to the chemical formula (1):

$$0 < x \leq 0.64 \qquad (3)$$

$$0.50 \geq y \geq 0.11 \qquad (4)$$

$$0.22 \leq x \leq 0.90 \qquad (5)$$

$$0.32 \geq y > 0 \qquad (6)$$

Example 2

In the example 2, the active layer 4 is formed of ZnSSe or ZnCdS whose band gap Eg is nearly equal to 2.8eV. The composition of the first and second cladding layers 2 and 3 is selected so as to satisfy Eg $\geq$ 3.leV in the composition expressed by the chemical formula (1) and the equations (1) and (2).

In the first and second cladding layers 2 and 3, the difference $\Delta$Eg between the band gaps Eg thereof and the band gap Eg of the active layer 4 can be increased by increasing the value x more, which can as a result enhance an optical confinement. However, if the value of x is increased too much, i.e., the adding amount of Mg is increased too much, then the cladding layers 2 and 3 are activated so that they tend to be affected by impurities. Further, emission characteristics of the laser are deteriorated, fluctuated and become unstable due to the deterioration of crystal property when the three-dimensional growth occurs. For this reason, the value of x is preferably selected to be as small as possible in the range of the equation (1) so as to satisfy the difference $\Delta$Eg between the band gaps Eg of the cladding layers 2, 3 and that of the active layer 4 as Eg $\geq$ 0.3eV.

Example 3

In a wide variety of semiconductor lasers such as photo-excited type semiconductor laser, electron beam induced type semiconductor laser or p-n junction type semiconductor laser, the first and second cladding layers 2 and 3 are formed of MgS$_z$Se$_{1-z}$ (0.85 $\leq$ z $\leq$ 0.95), e.g., MgS$_{0.89}$Se$_{0.11}$ (Eg = 4.4 eV) and the active layer 4 is formed of Mg$_i$Cd$_{1-i}$S (0.80 $\leq$ i $\leq$ 0.90), e.g., Mg$_{0.86}$Cd$_{0.14}$S (Eg = 4.2eV).

Example 4

In a variety of semiconductor lasers such as photo-excited type semiconductor laser, electron beam induced type semiconductor laser or p-n junction type semiconductor laser, the substrate 1 is formed of an InP substrate and the first and second cladding layers 2, 3 and the active layer 4 are arranged to have the composition expressed by the following chemical formula (2) wherein j and k expressing atomic ratios are selected in the following equations (7) and (8):

$$Mg_j Zn_k Cd_{1-j-k} Se \qquad (2)$$

$$0 < j \leq 0.95 \qquad (7)$$

$$0.50 \geq k \geq 0.05 \qquad (8)$$

According to the above-mentioned composition, the respective layers 2 to 4 can be matched with the InP substrate 1 satisfactorily.

In the above-mentioned composition, the band gap Eg of the active layer 4 is selected to be smaller than the band gaps Eg of the first and second cladding layers 2, 3 and the difference $\Delta$Eg therebetween is selected to be larger than at least 0.2eV and preferably larger than 0.3eV. Thus, when the band gap Eg of the active layer 4 is selected to be 2.3eV to 3.2eV in the wavelength of about 5390 Å to 3874 Å), then the band gaps Eg of the first and second cladding layers 2 and 3 are selected to be 2.6eV to 3.5eV which are constantly higher than the band gap Eg of the active layer 4 by 0.3ev. In order for the active layer 4 to have a band gap expressed by 2.3eV $\leq$ Eg $\leq$ 3.2eV, in the composition expressed by the aforesaid chemical formula (2), the following equations (9) and (10) must be satisfied in the above-mentioned chemical formula (2). In that event, atomic ratios j, k of the cladding layers 2 and 3 must satisfy the following equations (11) and (12) in the above-mentioned chemical formula (2):

$$0 < j \leq 0.69 \qquad (9)$$

$$0.50 \geq k \geq 0.18 \qquad (10)$$

$$0.23 \leq j \leq 0.95 \qquad (11)$$

$$0.37 \geq k \geq 0.05 \qquad (12)$$

## Example 5

In the example 5, the active layer 4 is formed of $CdS_qSe_{1-q}$ or $Zn_rCd_{1-r}Se$ (q and r are both atomic ratios and expressed as $0.78 \leq q \leq 0.88$ and $0.42 \leq r \leq 0.52$). Band gaps Eg of $CdSqSe_{1-q}$ and $Zn_rCd_{1-r}Se$ are both nearly equal to 2.3eV. The cladding layers 2 and 3 may be formed by the composition expressed by the aforesaid chemical formula (2). In this case, the atomic ratios j and k of the cladding layers 2 and 3 must be selected as $j \geq 0.23$ and $k \leq 0.37$ in order to satisfy $Eg \geq 2.6eV$.

In the first and second cladding layers 2 and 3, the difference $\Delta Eg$ between the band gaps Eg thereof and the band gap Eg of the active layer 4 can be increased by selecting the value j larger than 0.23 and the value k smaller than 0.37, which can as a result enhance an optical confinement. However, if the value of j is increased too much, i.e., the adding amount of Mg is increased too much, then the cladding layers 2 and 3 are activated so that they tend to be affected by impurities. Further, the emission characteristics of the laser are deteriorated, fluctuated and become unstable due to the deterioration of crystal property when the three-dimensional growth occurs. Further, from a matching property standpoint with the InP substrate, the atomic ratios, j and k of the cladding layers 2 and 3 are selected so as to satisfy $0.95 \geq j \geq 0.23$ and $0.05 \leq k \leq 0.37$.

## Example 6

In a variety of semiconductor lasers such as photo-excited type semiconductor laser, electron beam induced type semiconductor laser or p-n junction type semiconductor laser, the first and second cladding layers 2, 3 and the active layer 4 are arranged to have the composition expressed by the following chemical formula (3) wherein $\ell$ and m express atomic ratios are selected in the following equations (13) and (14):

$$Mg_\ell Cd_{1-\ell}S_m Se_{1-m} \qquad (3)$$

$$0 < \ell \leq 1 \qquad (13)$$

$$0.88 \geq m \geq 0.03 \qquad (14)$$

The respective layers 2 to 4 having these compositions can be well matched with the InP substrate.

In the above-mentioned compositions, the band gap Eg of the active layer 4 is selected to be smaller than the band gaps Eg of the first and second cladding layers 2, 3 and the difference $\Delta Eg$ therebetween is selected to be larger than at least 0.2eV and preferably larger than 0.3eV. Then, the band gap Eg can be selected to be 2.4eV to 3.7eV in the range expressed by the equation (13) with respect to the chemical formula (3) so that the band gap Eg of the active layer 4 is selected to be 2.4eV ($Eg = 2.4eV$), then the band gaps Eg of the cladding layers 2, 3 are selected so as to satisfy $Eg \geq 2.7eV$. Therefore, the atomic ratios $\ell$ and m of the cladding layers 2 and 3 are selected to so as to satisfy $\ell \geq 0.20$ and $m \leq 0.70$.

## Example 7

In semiconductor lasers such as photo-excited type semiconductor laser, electron beam induced type semiconductor laser or p-n junction type semiconductor laser, the first and second cladding layers 2, 3 are formed of $MgS_nSe_{1-n}$ ($0.03 \leq n \leq 0.13$), e.g., $MgS_{0.08}Se_{0.92}$ ($Eg = 3.8eV$) and the active layer 4 is formed of $Mg_pZn_{1-p}Se$ ($0.85 \leq p \leq 0.95$), e.g., $Mg_{0.91}Zn_{0.09}Se$ ($Eg = 3.8eV$).

In the semiconductor lasers according to the above-mentioned examples 1 to 7, since by the addition of Mg the active layer 4 is optically confined by the cladding layers 2 and 3 having large band gaps which can be satisfactorily matched with the GaAs substrate or InP substrate 1 having large lattice constant, the band gap of the active layer 4 can be increased, thereby making it possible to emit a laser beam of short wavelength ranging from green, purple to ultraviolet.

In the present invention, Mg is added to the cladding layer, for example. In this case, if there is then the risk that the surface of the cladding layer is oxidized when the cladding layer containing Mg opposed to the surface of the semiconductor laser is left under high humidity and high temperature for a long period of time, as shown in FIG. 2, a capping layer 5 containing no Mg and which is difficult to be oxidized is epitaxially grown on the cladding layer 3, i.e., the upper (second cladding layer) cladding layer after the cladding layer is epitaxially grown on the active layer 4.

The capping layer 5 is formed of ZnS or ZnSe, for example, which is easy to be formed into an n-type capping layer and which is difficult to be oxidized if the cladding layer 3 under the capping layer 5 is the n-type layer. Alternatively, the capping layer 5 might be formed of ZnTe, for example, which is easy to be formed into a p-type capping layer and which is difficult to be oxidized if the cladding layer 3 is the p-type layer.

In FIG. 2, like parts corresponding to those of FIG. 1 are marked with the same references and therefore need not be described in detail.

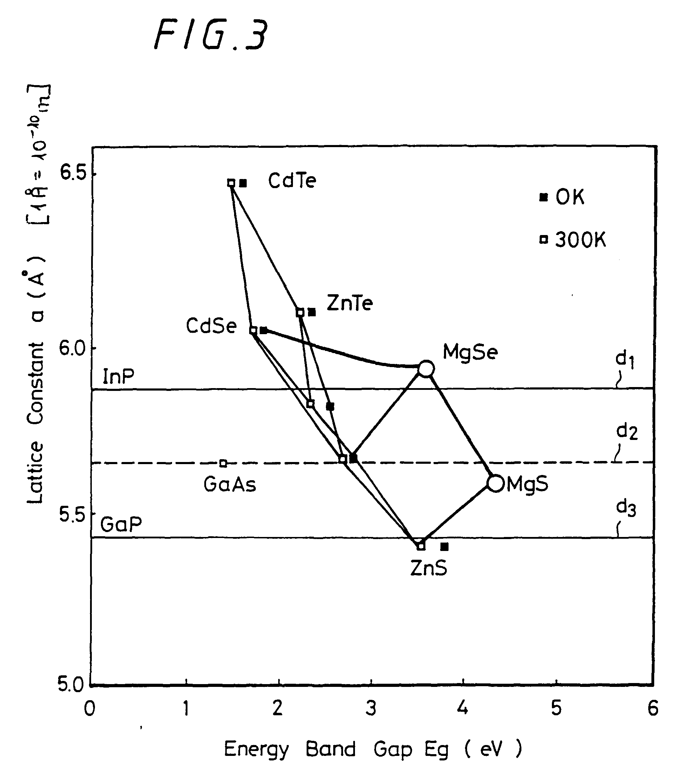

In the above-mentioned examples 1 through 7, the first and second cladding layers 2, 3 and the active layer 4 can be grown as the layers having excellent crystal property which can be satisfactorily matched with the GaAs substrate or InP substrate 1 from a lattice standpoint. Study of a relation between lattice constants a of two element compositions and band gap Eg shown in FIG. 3 demonstrates that the cladding layers 2, 3 and the active layer 4 can be matched with the GaAs substrate or InP substrate 1 satisfactorily. Straight lines $d_1$,

$d_2$ and $d_3$ in FIG. 3 show lattice constant positions of InP, GaAs and Gap, respectively.

According to the present invention, since the semiconductor laser capable of emitting a laser beam of short wavelength can be constructed by using commercially-available inexpensive GaAs substrate or InP substrate having excellent crystal property, the semiconductor laser of the present invention is used as a light source for effecting optical recording, magneto-optical recording, optical reproducing or magneto-optical reproducing, for example, thereby making it possible to effect high density recording and high resolution recording. Further, the semiconductor laser of the present invention can bring about great advantages, in actual practice, such as reduction of electric power consumption, color display of high brightness or color image reproduction.

Having described preferred embodiments of the invention with reference to the accompanying drawings, it is to be understood that the invention is not limited to those precise embodiments and that various changes and modifications could be effected therein by one skilled in the art without departing from the scope of the invention as defined in claims 1 and 5.

## Claims

1. A semiconductor laser comprising:

    a GaAs substrate (1),
    a lower cladding layer (2) on said substrate (1),
    an active layer (4) on said lower cladding layer (2),
    an upper cladding layer (3) on said active layer (4),

    wherein at least one of said lower and upper cladding layers are formed of a II-VI group compound semiconductor, **characterized in that** said semiconductor is of the $Mg_xZn_yCd_{1-x-y}S$ system or $MgS_zSe_{1-z}$ system, and when it is of the $MgS_zSe_{1-z}$ system, said active layer is formed of a II-VI-group compound semiconductor of the $Mg_iCd_{1-i}S$ system.

2. The semiconductor laser according to claim 1, wherein said semiconductor is of the $Mg_xZn_yCd_{1-x-y}S$ system, wherein x and y expressing atomic ratios are limited to $0 < x \leq 0.90$ and $0.50 \geq y > 0$.

3. The semiconductor laser according to claim 2, wherein said active layer (4) is formed of a II-VI group compound semiconductor of $Mg_xZn_yCd_{1-x-y}S$ system, wherein x and y expressing atomic ratios are limited to $0 < x \leq 0.64$ and $0.50 \geq y > 0.11$.

4. The semiconductor laser according to claim 1, wherein z and i expressing atomic ratios are limited to $0.85 \leq z \leq 0.95$ and $0.80 \leq i \leq 0,90$.

5. A semiconductor laser comprising:

    an InP substrate (1),
    a lower cladding layer (2) on said substrate (1),
    an active layer (4) on said lower cladding layer (2), and
    an upper cladding layer (3) on said active layer (4),

    wherein at least one of said lower and upper cladding layers is formed of a II-VI group compound semiconductor, **characterized in that** said semiconductor is of the $Mg_jZn_kCd_{1-j-k}Se$ system or $MgS_nSe_{1-n}$ system or $Mg_\ell Cd_{1-\ell}S_mSe_{1-m}$ system.

6. The semiconducor laser according to claim 5, wherein said semiconductor is of the $Mg_jZn_kCd_{1-j-k}Se$ system, wherein j and k expressing atomic ratios are limited to $0 < j \leq 0.95$ and $0.50 \geq k \geq 0.05$.

7. The semiconductor laser according to claim 6, wherein said active layer is formed of $Mg_jZn_kCd_{1-j-k}Se$, wherein j and k expressing atomic ratios are limited to $0 < j \leq 0.69$ and $0.50 \geq k \geq 0.18$.

8. The semiconductor laser according to claim 5, wherein said active layer is formed of a II-VI group compound semiconductor of the CdSSe system or ZnCdSe system and said cladding layers are formed of $Mg_jZn_kCd_{1-j-k}Se$, wherein j and k expressing atomic ratios are limited to $0.23 \leq j \leq 0.95$ and $0.37 \geq k \geq 0.05$.

9. The semiconductor laser according to claim 5, wherein at least one of said cladding layers is formed of $Mg_\ell Cd_{1-\ell}S_mSe_{1-m}$, wherein $\ell$ and m expressing atomic ratios are limited to $0 < \ell \leq 1$ and $0.88 \geq m \geq 0.03$.

10. The semiconductor laser according to claim 5, wherein at least one of said lower and upper cladding layers is formed of $MgS_nSe_{1-n}$, and said active layer is formed of $Mg_pZn_{1-p}Se$.

11. The semiconductor laser according to claim 10, wherein said n and p expressing atomic ratios are limited to $0.03 \leq n \leq 0.13$ and $0.85 \leq p \leq 0.95$.

12. The semiconductor laser according to any of claims 1-11, further comprising a capping layer (5) which does not contain Mg and is difficult to be oxidized on said upper cladding layer (3).

**Patentansprüche**

1. Halbleiterlaser, umfassend:

   ein GaAs-Substrat (1),
   eine untere Überzugsschicht (2) auf dem Substrat (1),
   eine aktive Schicht (4) auf der unteren Überzugsschicht (2),
   eine obere Überzugsschicht (3) auf der aktiven Schicht (4),

   wobei mindestens eine der unteren und der oberen Überzugschicht aus einem Halbleiter einer Gruppe II-VI-Verbindung gebildet ist, **dadurch gekennzeichnet**, daß der Halbleiter dem $Mg_xZn_yCd_{1-x-y}S$-System oder $MgS_zSe_{1-z}$-System angehört, und wenn er dem $MgS_zSe_{1-z}$-System angehört, die aktive Schicht aus einem Halbleiter einer Gruppe II-VI-Verbindung des $Mg_iCd_{1-i}S$-Systems gebildet ist.

2. Halbleiterlaser nach Anspruch 1, wobei der Halbleiter dem $Mg_xZn_yCd_{1-x-y}S$-System angehört, worin x und y, welche Atomverhältnisse angeben, auf $0 < x \leq 0,90$ und $0,50 \geq y > 0$ beschränkt sind.

3. Halbleiterlaser nach Anspruch 2, wobei die aktive Schicht (4) aus einem Halbleiter einer Gruppe II-VI-Verbindung des $Mg_xZn_yCd_{1-x-y}S$-Systems gebildet ist, worin x und y, welche Atomverhältnisse angeben, auf $0 < x \leq 0,64$ und $0,50 \geq y > 0,11$ beschränkt sind.

4. Halbleiterlaser nach Anspruch 1, worin z und i, welche Atomverhältnisse angeben, auf $0,85 \leq z \leq 0,95$ und $0,80 \leq i \leq 0,90$ beschränkt sind.

5. Halbleiterlaser, umfassend

   ein InP-Substrat (1),
   eine untere Überzugsschicht (2) auf dem Substrat (1),
   eine aktive Schicht (4) auf der unteren Überzugsschicht (2), und

   eine obere Überzugsschicht (3) auf der aktiven Schicht (4), wobei mindestens eine der unteren und oberen Überzugsschicht aus einem Halbleiter einer Gruppe II-VI-Verbindung gebildet ist, **dadurch gekennzeichnet**, daß der Halbleiter dem $Mg_jZn_kCd_{1-j-k}Se$-System oder $MgS_nSe_{1-n}$-System oder $Mg_\ell Cd_{1-\ell}S_mSe_{1-m}$-System angehört.

6. Halbleiterlaser nach Anspruch 5, wobei der Halbleiter dem $Mg_jZn_kCd_{1-j-k}Se$-System angehört, worin j und k, welche Atomverhältnisse angeben, auf $0 < j \leq 0,95$ und $0,50 \geq k \geq 0,05$ beschränkt sind.

7. Halbleiterlaser nach Anspruch 6, wobei die aktive Schicht aus $Mg_jZn_kCd_{1-j-k}Se$ gebildet ist, worin j und k, welche Atomverhältnisse angeben, auf $0 < j \leq 0,69$ und $0,50 \geq k \geq 0,18$ beschränkt sind.

8. Halbleiterlaser nach Anspruch 5, wobei die aktive Schicht aus einem Halbleiter einer Gruppe II-VI-Verbindung des CdSSe-Systems oder ZnCdSe-Systems gebildet ist, und die Überzugsschichten aus $Mg_jZn_kCd_{1-j-k}Se$ gebildet sind, worin j und k, welche Atomverhältnnisse angeben, auf $0,23 \leq j \leq 0,95$ und $0,37 \geq k \geq 0,05$ beschränkt sind.

9. Halbleiterlaser nach Anspruch 5, wobei mindestens eine der Überzugsschichten aus $Mg_\ell Cd_{1-\ell}S_mSe_{1-m}$ gebildet ist, worin $\ell$ und m, welche Atomverhältnisse angeben, auf $0 < \ell \leq 1$ und $0,88 \geq m \geq 0,03$ beschränkt sind.

10. Hableiterlaser nach Anspruch 5, wobei mindestens eine der unteren und oberen Überzugsschicht aus $MgS_nSe_{1-n}$ gebildet ist, und wobei die aktive Schicht aus $Mg_pZn_{1-p}Se$ gebildet ist.

11. Halbleiterlaser nach Anspruch 10, wobei n und p, welche Atomverhältnisse angeben, auf $0,03 \leq n \leq 0,13$ und $0,85 \leq p \leq 0,95$ beschränkt sind.

12. Halbleiterlaser nach mindestens einem der Ansprüche 1-1 1, umfassend weiterhin eine Abdeckungsschicht (5), welche kein Mg enthält, und der auf der oberen Überzugschicht (3) schwierig zu oxidieren ist.

**Revendications**

1. Laser à semiconducteur comportant:

   un substrat GaAs (1),
   une couche de placage inférieure (2) sur ledit substrat (1),
   une couche active (4) sur ladite couche de placage inférieure (2),
   une couche de placage supérieure (3) sur ladite couche active (4),

   dans lequel au moins l'une desdites couches de placage inférieure et supérieure sont formées d'un semiconducteur avec composé du groupe II-VI, caractérisé par le fait que ledit semiconducteur est du système $Mg_xZn_yCd_{1-x-y}S$ ou du système $MgS_zSe_{1-z}$ et, s'il est du système $MgS_zSe_{1-z}$, ladite couche active est formée d'un semiconducteur, avec composé du groupe II-VI, du système $Mg_iCd_{1-i}S$.

**2.** Laser à semiconducteur selon la revendication 1, dans lequel ledit semiconducteur est du système $Mg_xZn_yCd_{1-x-y}S$, où x et y, qui expriment le nombre d'atomes dans une molécule, sont limités à $0 < x \leq 0,90$ et $0,50 \geq y > 0$.

**3.** Laser à semiconducteur selon la revendication 1, dans lequel ladite couche active (4) est formée d'un semiconducteur avec composé du groupe II-VI, du système $Mg_xZn_yCd_{1-x-y}S$, où x et y, qui expriment le nombre d'atomes dans une molécule, sont limités à $0 < x \leq 0,64$ et $0,50 \geq y > 0,11$.

**4.** Laser à semiconducteur selon la revendication 1, où z et i, qui expriment le nombre d'atomes dans une molécule, sont limités à $0,85 \leq z \leq 0,95$ et $0,80 \leq i \leq 0,90$.

**5.** Laser à semiconducteur comportant:

un substrat InP (1),
une couche de placage inférieure (2) sur ledit substrat (1),
une couche active (4) sur ladite couche de placage inférieure (2) et
une couche de placage supérieure (3) sur ladite couche active (4),

dans lequel au moins l'une desdites couches de placage inférieure et supérieure est formée d'un semiconducteur, avec composé du groupe II-VI, caractérisé par le fait que ledit semiconducteur est du système $Mg_jZn_kCd_{1-j-k}Se$ ou du système $MgS_nSe_{1-n}$ ou du système $Mg_\ell CD_{1-\ell}S_mSe_{1-m}$.

**6.** Laser à semiconducteur selon la revendication 5, dans lequel ledit semiconducteur est du système $Mg_jZn_kCd_{1-j-k}Se$, où j et k, qui expriment le nombre d'atomes dans une molécule, sont limités à $0 < j \leq 0,95$ et $0,50 \geq k \geq 0,05$.

**7.** Laser à semiconducteur selon la revendication 6, dans lequel ladite couche active est formée de $Mg_jZn_kCd_{1-j-k}Se$ où j et k, qui expriment le nombre d'atomes dans une molécule, sont limités à $0 < j \leq 0,69$ et $0,50 \geq k \geq 0,18$.

**8.** Laser à semiconducteur selon la revendication 5, dans lequel ladite couche active est formée d'un semiconducteur avec composé du groupe II-VI, du système CdSSe ou du système ZnCdSe et lesdites couches de placage sont formées de $Mg_jZn_kCd_{1-j-k}Se$ où j et k, qui expriment le nombre d'atomes dans une molécule sont limités à $0,23 \leq j \leq 0,95$ et $0,37 \geq k \geq 0,05$.

**9.** Laser à semiconducteur selon la revendication 5, dans lequel au moins l'une desdites couches de placage est formée de $Mg_\ell CD_{1-\ell}S_mSe_{1-m}$ où $\ell$ et m, qui expriment le nombre d'atomes dans une molécule, sont limités à $0 < \ell \leq 1$ et $0,88 \geq m \geq 0,03$.

**10.** Laser à semiconducteur selon la revendication 5, dans lequel au moins l'une desdites couches de placage inférieure et supérieure est formée de $MgS_nSe_{1-n}$ et ladite couche active est formée de $Mg_pZn_{1-p}Se$.

**11.** Laser à semiconducteur selon la revendication 5, dans lequel lesdits n et p, qui expriment le nombre d'atomes dans une molécule, sont limités à $0,03 \leq n \leq 0,13$ et $0,85 \leq p \leq 0,95$.

**12.** Laser à semiconducteur selon l'une quelconque des revendications 1-11, comportant en outre, sur ladite couche de placage supérieure (3), une couche de couronnement (5) qui ne contient pas Mg et qui s'oxyde difficilement.

*FIG.1*

*FIG.2*

# FIG.3